# EUROPÄISCHE PATENTSCHRIFT

(11) **EP 3 551 955 B1**
(45) Veröffentlichungstag und Bekanntmachung des Hinweises auf die Patenterteilung: **09.09.2020**
(21) Anmeldenummer: 17837867.5
(22) Anmeldetag: 15.12.2017
(51) Int. Cl.: F28D 15/02, F28D 20/02, H01L 23/427

(54) **KÜHLVORRICHTUNG MIT EINEM WÄRMEROHR UND EINEM LATENTWÄRMESPEICHER, VERFAHREN ZUM HERSTELLEN DERSELBEN UND ELEKTRONISCHE SCHALTUNG**
COOLING DEVICE HAVING A HEAT PIPE AND A LATENT HEAT STORE, METHOD FOR PRODUCING SAME AND ELECTRONIC CIRCUIT
DISPOSITIF DE REFROIDISSEMENT COMPRENANT UN CALODUC ET UN ACCUMULATEUR DE CHALEUR LATENTE, PROCÉDÉ DE FABRICATION DE CELUI-CI ET CIRCUIT ÉLECTRONIQUE

(30) Priorität: 13.01.2017 DE 102017200524
(43) Veröffentlichungstag der Anmeldung: 16.10.2019
(73) Patentinhaber: Siemens Aktiengesellschaft, 80333 München (DE)
(72) Erfinder: HOFACKER, Oliver, 14199 Berlin (DE); REHME, Olaf, 20148Hamburg (DE); REZNIK, Daniel, 13503 Berlin (DE)
(86) Internationale Anmeldenummer: PCT/EP2017/082958
(87) Internationale Veröffentlichungsnummer: WO 2018/130367

(56) Entgegenhaltungen:
- DE-U1-202015 004 833
- KR-A- 20000 051 265
- US-A1- 2009 109 623
- US-A1- 2014 090 808

## Beschreibung

Die Erfindung betrifft eine Kühlvorrichtung mit einer thermischen Schnittstelle für eine zu kühlende Wärmequelle nach dem Oberbegriff des ersten Anspruchs. Solch eine Kühlvorrichtung ist aus KR2000 0051265 A1 bekannt. Diese thermische Schnittstelle ist normalerweise als Wärmeübertragungsfläche ausgeführt und liegt mit dieser an der zu kühlenden Wärmequelle an. Die Kühlvorrichtung weist in voneinander getrennten Volumina ein Wärmerohr mit einem ersten Phasenwechselmedium und einen Latentwärmespeicher mit einem zweiten Phasenwechselmedium auf. Weiterhin betrifft die Erfindung eine elektronische Schaltung, insbesondere eine leistungselektronische Schaltung, mit einer zu kühlenden Baukomponente. Zu kühlende Baukomponenten von leistungselektronischen Schaltungen können üblicherweise mit Kühlvorrichtungen ausgestattet werden, die über eine thermische Schnittstelle Wärme von der zu kühlenden Baukomponente (d.h. der Wärmequelle) aufnehmen können. Außerdem betrifft die Erfindung ein Verfahren zum Herstellen der genannten Kühlvorrichtung.

Eine Kühlvorrichtung der eingangs angegebenen Art ist beispielsweise aus der DE 20 2015 004 833 U1 bekannt. Die dort beschriebene Kühlanordnung zur Kühlung einer technischen Einrichtung weist einen Metallbehälter auf, der mit einem Phasenwechselmedium als Latentwärme speicherndnes Material (Phasenwechselmaterial) gefüllt ist. In dem Behälter verläuft außerdem ein Wärmerohr, mit dem Wärme aus dem Phasenwechselmaterial des Latentwärmespeichers aus dem Gehäuse heraus transportiert werden soll.

Als Anwendung für die Kühleinrichtung beschreibt die DE 20 2015 004 833 U1 die Möglichkeit, eine technische Einrichtung ohne Energieeinsatz am Tage zu kühlen, indem entstehende Wärme durch einen Phasenwechsel des Phasenwechselmaterials von fest zu flüssig gespeichert wird. Diese Wärme kann in der Nacht aufgrund der Abkühlung der Umgebungsluft über das Wärmerohr an die Umgebung abgegeben werden.

Gemäß der DE 10 2013 217 829 A1 ist es bekannt, dass Latentwärmespeicher auch zur Verbesserung der Kühlleistung von Kühlern im Falle des Auftretens von Lastspitzen beispielsweise bei elektronischen Schaltungen verwendet werden können. Das Phasenwechselmaterial kann die mit Lastspitzen verbundene Wärmeentwicklung aufnehmen, indem das Phasenwechselmedium einen Phasenwechsel von fest zu flüssig vollzieht, d. h. schmilzt. Später kann diese Wärme durch Erstarren des Phasenwechselmediums über den Kühler abgegeben werden, wenn die eigentliche Wärmequelle weniger Wärme erzeugt.

Der Vorteil der letztgenannten Lösung liegt darin, dass die Kühlleistung des Kühlsystems nicht auf das Auftreten von Lastspitzen, sondern auf den Dauereinsatz ausgelegt werden kann. Hierdurch ist es möglich, das Kühlsystem insgesamt kompakter und leichter auszuführen. Beispiele für Anwendungen solcher Kühlsysteme sind die Leistungselektronik bei Schaltvorgängen oder Umrichter von Elektromotoren, die kurzzeitig hohe Leistung erbringen müssen (Lastspitzen), wie z. B. beim elektrischen Fliegen während der Steigflugphase. Dabei muss die bei der Lastspitze anfallende Wärmemenge berücksichtigt werden, um die erforderliche Wärmekapazität des Latentwärmespeichers zu bestimmen.

Die Wärmeleitfähigkeit von Phasenwechselmedien, wie beispielsweise Salzen oder Parafinen, ist jedoch begrenzt. Um einen schnelleren Wärmeeintrag in das Phasenwechselmedium zu erreichen, wird gemäß der EP 2 236 970 A1 vorgeschlagen, dass in dem Phasenwechselmedium eine Wärmeleitstruktur angeordnet wird, die aus einem dreidimensionalen Raumgitter besteht. Über dieses Raumgitter, welches eine große Oberfläche für einen Wärmeübergang zur Verfügung stellt, kann die Wärme schneller an die Umgebung des Latentwärmespeichers abgegeben werden.

Die Aufgabe der Erfindung besteht darin, eine Kühlvorrichtung bzw. eine elektronische Schaltung der eingangs angegebenen Art anzugeben, bei der eine Kühlung (Entwärmung) mit vergleichsweise wenig Materialaufwand (d. h. mit leichten und kompakten Strukturen) möglich ist. Außerdem besteht die Aufgabe der Erfindung darin, ein Verfahren zum Herstellen einer solchen Kühlvorrichtung anzugeben.

Diese Aufgabe wird mit der eingangs angegebenen Kühlvorrichtung erfindungsgemäß dadurch gelöst, dass die Schmelztemperatur des zweiten Phasenwechselmediums höher ist, als die Verdampfungstemperatur des ersten Phasenwechselmediums. Damit wird erfindungsgemäß erreicht, dass im Normalbetrieb der Kühlvorrichtung nur das erste Phasenwechselmedium in dem Wärmerohr zum Einsatz kommt. Die Wärme wird dabei über die thermische Schnittstelle in eine Wärmeaufnahmezone des Wärmerohrs eingeleitet, führt dort zur Verdampfung des ersten Phasenwechselmediums und wird in einer Wärmeabgabezone bei gleichzeitiger Kondensation des ersten Phasenwechselmediums an die Umgebung abgegeben. Im Normalbetrieb erwärmt sich daher die Kühlvorrichtung nicht soweit, dass es zu einem Schmelzen des zweiten Phasenwechselmediums in dem Latentwärmespeicher kommt, da die Schmelztemperatur des zweiten Phasenwechselmediums über der Verdampfungstemperatur des ersten Phasenwechselmediums liegt.

Vorteilhaft steht daher die Wärmekapazität des Latentwärmespeichers als Reserve beispielsweise zur effektiven Kühlung von Lastspitzen oder zur Vermeidung instabiler Betriebszustände im Wärmerohr zur Verfügung. Im Latentwärmespeicher wird die im Rahmen einer Lastspitze anfallende Wärme temporär als Schmelzwärme gespeichert. Fällt die Temperatur nach einem Abklingen der Lastspitze in der Kühlvorrichtung wieder unterhalb der Schmelztemperatur des zweiten Phasenwechselmediums, so wird während der Erstarrung desselben die Wärme an das Wärmerohr abgegeben. Anders ausgedrückt dient das Wärmerohr in diesem Betriebszustand gleichzeitig zur Kühlung des Latentwärmespeichers und der eigentlich zu kühlenden Wärmequelle.

Insgesamt muss die Entwärmungsleistung des Wärmerohrs damit nicht für das Auftreten von Lastspitzen der Wärmequelle ausgelegt werden. Um diese aufzufangen, steht erfindungsgemäß der Latentwärmespeicher zur Verfügung. Die Entwärmungsleistung des Wärmerohrs muss allerdings gewährleisten, dass im Normalbetrieb zusätzlich die Wärme abgeführt werden kann, die bei Auftreten von Lastspitzen im Latentwärmespeicher gespeichert wird. Insgesamt kann die Kühlvorrichtung damit kompakter und leichter ausgeführt werden, wobei der Mehraufwand für den Latentwärmespeicher durch die Einsparungen bei dem Wärmerohr überkompensiert werden.

Für die Auslegung der erfindungsgemäßen Kühlvorrichtung sind damit zwei Temperaturen von Bedeutung. Für den Betrieb unter Normalbedingungen ist die Temperatur maßgeblich, bei der das Wärmerohr seine Funktion entfaltet. Diese Temperatur ist durch die Siedetemperatur des in dem Wärmerohr eingeschlossenen ersten Phasenwechselmediums vorgegeben. Die zweite Temperatur ist die Schmelztemperatur des zweiten Phasenwechselmediums. Diese Temperatur wird im Bedarfsfall durch die aufzubringende Schmelzenthalpie des zweiten Phasenwechselmediums stabilisiert, weswegen im Rahmen der Kapazität des Latentwärmespeichers die Temperatur der Kühlvorrichtung nicht weiter ansteigt. Die Auslegung des Latentwärmespeichers muss so erfolgen, dass im Falle von Lastspitzen eine genügende Wärmekapazität des Latentwärmespeichers zur Verfügung steht. Die Wirkung des Latentwärmespeichers ist auf die Dauer beschränkt, bis das zweite Phasenwechselmedium komplett aufgeschmolzen wurde.

Als Wärmerohr im Zusammenhang dieser Anmeldung ist ein Wärmeüberträger zu verstehen, der die Verdampfungswärme des ersten Phasenwechselmediums zum Wärmetransport nutzt. In einer Wärmeaufnahmezone des Wärmerohrs verdampft das erste Phasenwechselmedium und kühlt diese aufgrund der für diesen Vorgang erforderlichen Verdampfungswärme. In einer Wärmeabgabezone des Wärmerohrs kondensiert das erste Phasenwechselmedium und gibt die Verdampfungswärme in diesem Bereich an die Umgebung ab. Für diese Funktion ist eine Bauform erforderlich, die eine Wärmeaufnahmezone und eine Wärmeabgabezone vorsieht. Hierbei muss die Geometrie des Wärmerohrs nicht zwangsläufig rohrförmig sein. Die Bezeichnung "Wärmerohr" bezeichnet lediglich eine bestimmte Funktionsweise zur Kühlung, wobei das Wärmerohr ein Volumen zur Aufnahme des ersten Phasenwechselmaterials zur Verfügung stellt, welches gegenüber der Umgebung abgeschlossen ist.

Das Wärmerohr kann als Thermosyphon ausgeführt sein, wobei bei dieser Bauform die Wärmeabgabezone geodätisch oberhalb der Wärmeaufnahmezone liegt, so dass das verdampfte erste Phasenwechselmedium nach oben steigen kann, um dort zu kondensieren und in flüssigem Zustand wieder nach unten zu laufen.

Eine andere Bauform des Wärmerohrs wird als Heatpipe bezeichnet. In diesem Fall können die Wärmeabgabezone und die Wärmeaufnahmezone unabhängig von ihrer geodätischen Lage angeordnet werden. Um einen Rücktransport des flüssigen ersten Phasenwechselmediums zu gewährleisten, werden in der Heatpipe vorzugsweise an der Innenwand kapillare Kanäle vorgesehen, die beispielsweise durch eine poröse Struktur gebildet sein können. Die kapillaren Kanäle der kapillaren Struktur bewirken aufgrund des Kapillareffekts einen Transport des flüssigen ersten Phasenwechselmediums von der Wärmeabgabezone zur Wärmeaufnahmezone. Aufgrund eines sich ausbildenden Druckgefälles strömt das verdampfte erste Phasenwechselmedium von der Wärmeaufnahmezone zur Wärmeabgabezone.

Gemäß einer vorteilhaften Ausgestaltung der Erfindung ist vorgesehen, dass die Schmelztemperatur des zweiten Phasenwechselmediums weniger als 20 K bevorzugt weniger als 10 K höher ist als die Verdampfungstemperatur des ersten Phasenwechselmediums. Hierdurch ist sichergestellt, dass das zweite Phasenwechselmedium bei einer Erhöhung der Temperatur in dem Wärmerohr rechtzeitig zu schmelzen beginnt, um eine weitere Temperaturerhöhung zu verhindern. In diesem Temperaturbereich ist das Wärmerohr immer noch arbeitsfähig, so dass ein gleichzeitiger Wärmetransport in den Latentwärmespeicher und durch das Wärmerohr gewährleistet ist. In diesem Zustand ist die Kühlleistung der Kühlvorrichtung vorteilhaft besonders hoch und die Kapazität des Latentwärmespeichers reicht für einen längeren Zeitraum einer Lastspitze, als wenn die Temperaturerhöhung die Wirkung des Wärmerohrs wegen eines Austrocknens der Wärmeaufnahmezone vollständig außer Kraft setzen würde.

Allerdings ist es auch in einem Betriebszustand, in dem die Funktion des Wärmerohrs zusammenbricht, möglich, dass der Latentwärmespeicher die Wärme temporär aufnimmt, so dass die Funktion des Wärmerohrs sich bei einem Sinken des Wärmestroms aus der Wärmequelle wieder einstellt. Es handelt sich hierbei vorteilhaft um ein selbsthelfendes System. Solange die Wärmekapazität des Latentwärmespeichers nicht ausgeschöpft ist, schützt dieser ein ausgetrocknetes Wärmerohr vor Beschädigungen aufgrund einer thermischen Überlastung.

Gemäß der Erfindung ist vorgesehen, dass das Wärmerohr und der Latentwärmespeicher durch zwei ineinander verschachtelte Raumstrukturen gebildet sind. Dies hat den Vorteil, dass für einen Austausch von Wärme zwischen dem Wärmerohr und dem Latentwärmespeicher eine große Oberfläche zur Verfügung steht, so dass sowohl bei Auftreten von Lastspitzen eine schnelle Einleitung von Wärme aus dem Wärmerohr in den Latentwärmespeicher möglich ist, als auch die Rückführung der Wärme aus dem Latentwärmespeicher in das Wärmerohr während des Normalbetriebs schnell erfolgen kann. Vorteilhaft ist die Kühlvorrichtung daher auch bei schnellen Lastwechseln thermisch stabil.

Gemäß einer weiteren Ausgestaltung der Erfindung ist vorgesehen, dass der Latentwärmespeicher durch ein hohles Raumgitter gebildet wird. Das zweite Phasenwechselmaterial ist in einem in dem Raumgitter als Latentwärmespeicher gebildeten Hohlraum eingeschlossen. Das erste Phasenwechselmaterial ist in durch das Gitter gebildeten Gitterzwischenräumen untergebracht. Die Wände des hohlen Gitters sind damit als Trennwand zwischen dem ersten und dem zweiten Volumen vorgesehen. Hierdurch steht vorteilhaft eine große Fläche für den Wärmeübergang zur Verfügung. Außerdem stellt das Gitter für die Bildung des Hohlraums einen vergleichsweise geringen Querschnitt zur Verfügung, so dass sich die Wärme ins Innere des zweiten Phasenwechselmaterials auch bei einer vergleichsweise geringen Wärmeleitfähigkeit schnell ausbreiten kann.

Gemäß einer wieder anderen Ausgestaltung der Erfindung ist vorgesehen, dass der Latentwärmespeicher eine Vielzahl von Teilräumen aufweist, die im Wärmerohr gehalten sind. Die Halterung der Teilräume im Wärmerohr kann beispielsweise durch Rippen erfolgen. Außerdem ist es möglich, dass die Teilräume untereinander fluidisch verbunden sind. Diese fluidischen Verbindungen, beispielsweise in Form von rohrartigen Verbindungen, dienen dann gleichzeitig der Halterung der Teilräume des Latentwärmespeichers im Wärmerohr und erleichtern das Befüllen des Latentwärmespeichers mit dem zweiten Phasenwechselmedium. Die Aufteilung des Latentwärmespeichers in Teilräume hat, wie bereits beschrieben, den Vorteil, dass die für einen Wärmeübergang zwischen Wärmerohr und Latentwärmespeicher zur Verfügung stehende Fläche vergrößert wird und die Kühlvorrichtung daher schnell auf Lastwechsel der Wärmequelle reagieren kann.

Weiterhin kann vorteilhaft vorgesehen werden, dass mehrere Wärmerohre vorgesehen sind, die von dem Latentwärmespeicher umgeben sind. Diese Bauform hat den Vorteil, dass die Wärmerohre unabhängig voneinander funktionsfähig sind. Sollte beispielsweise wegen Auftretens einer lokal begrenzten Lastspitze eines der Wärmerohre austrocknen, so wird die Kühlleistung der anderen Wärmerohre hiervon nicht betroffen. Lokal kann der Latentwärmespeicher in diesem Bereich die Kühlleistung übernehmen und bereits Wärme an benachbarte Wärmerohre abgeben, bis das betreffende Wärmerohr durch Kühlung wieder befeuchtet wird und seine Funktion zur Kühlung der überhitzten Stelle wieder aufnimmt. Hierdurch wird das System vorteilhaft robuster gegenüber der Ausbildung lokaler Wärmespitzen (hot spots).

Weiterhin kann vorgesehen werden, dass das Wärmerohr (oder die Wärmerohre) in einer Wärmeabgabezone außen mit einer passiven Kühlstruktur versehen sind. Passive Kühlstrukturen funktionieren nach dem Prinzip der Oberflächenvergrößerung und können gemäß einer besonderen Ausgestaltung der Erfindung beispielsweise aus Rippen oder aus einem Raumgitter (oder aus Rippen und einem Raumgitter) bestehen. Die Wärme aus dem Wärmerohr wird dann aufgrund der Wärmeleitung an die passive Kühlstruktur übertragen, so dass eine größere Fläche zur Abstrahlung der Wärme in die Umgebung zur Verfügung steht. Die Kühlleistung der Kühlvorrichtung kann auf diesem Wege vorteilhaft verbessert werden.

Wenn das Wärmerohr als Heatpipe ausgeführt ist, kann gemäß einer besonderen Ausgestaltung der Erfindung eine kapillare Wandstruktur des Wärmerohrs mit demselben in einem Stück ausgeführt sein. Dies lässt sich beispielsweise mit einem additiven Fertigungsverfahren erreichen, bei dem die kapillare Wandstruktur zusammen mit einer das Volumen des Wärmerohrs hermetisch gegen die Umgebung abdichtenden massiven Wandstruktur in ein und demselben Fertigungslauf hergestellt wird. Hierbei kommt für die Herstellung der kapillaren Wandstruktur und der massiven Wandstruktur vorzugsweise dasselbe Baumaterial zum Einsatz. Der Vorteil einer einstückigen Ausführung liegt insbesondere darin, dass zwischen dem massiven und dem kapillaren Teil der Wand ein schneller Wärmeübergang stattfinden kann.

Gemäß einer besonders vorteilhaften Ausführung der Erfindung ist vorgesehen, dass in dem Latentwärmespeicher eine Wärmeleitstruktur angeordnet ist, die mit der Wand des Latentwärmespeichers verbunden ist. Die Verbindung mit der Wand führt einerseits zu einer mechanischen Fixierung der Wärmeleitstruktur im Inneren des Latentwärmespeichers. Außerdem ermöglicht die Verbindung mit der Wand einen Wärmeübergang zwischen der Wärmeleitstruktur und der Wand des Latentwärmespeichers, so dass Wärme vorteilhaft schneller in das zweite Phasenwechselmedium eingeleitet oder ausgeleitet werden kann (je nach Betriebszustand). Vorteilhaft besteht die Wärmeleitstruktur daher aus einem im Vergleich zum zweiten Phasenwechselmedium besseren Wärmeleiter, vorzugsweise aus einem Metall oder einer Metalllegierung. Vorzugsweise ist die Wärmeleitstruktur in Form von Rippen und/oder in Form eines Raumgitters ausgeführt.

Die oben genannte Aufgabe wird auch durch eine elektronische Schaltung mit einer zu kühlenden Baukomponente, wie z. B. einem leistungselektronischen Bauelement, dadurch gelöst, dass erfindungsgemäß die Baukomponente mit der thermischen Schnittstelle einer Kühlvorrichtung der oben beschriebenen Art verbunden ist. Hierdurch werden beim Betrieb der elektronischen Schaltung die oben bereits erläuterten Vorteile erreicht, insbesondere, dass die Kühlvorrichtung vergleichsweise kompakt und leicht dimensioniert sein kann und trotzdem bei auftretenden Lastspitzen die elektronische Schaltung zuverlässig gekühlt werden kann.

Vorteilhaft kann vorgesehen werden, dass die maximal mögliche Kühlleisung des Wärmerohrs der Kühlvorrichtung größer oder gleich der Wärmeleistung der Baukomponente bei Nennlast der Baukomponente ist, so dass im Normalbetrieb die Kühlleisung des Wärmerohrs dauerhaft für eine Kühlung ausreicht. Die Kühlleistung ist aber kleiner als die Wärmeleistung der Baukomponente bei einer zugelassenen Spitzenlast, so dass bei Auftreten der Lastspitzen bis zur zugelassenen Spitzenlast der Latentwärmespeicher zum Einsatz kommt. Die Nennlast und zulässige Spitzenlast sind Kennwerte der Baukomponente. Die Höhe der zulässigen Spitzenlast ist auch abhängig von der Dauer ihres Auftretens, da der Latentwärmespeicher nur eine bestimmte Wärmekapazität zur Verfügung stellt.

Außerdem wird die oben angegebene Aufgabe durch ein Verfahren zum Herstellen einer Kühlvorrichtung der oben angegebenen Art gelöst, wobei zur Herstellung erfindungsgemäß ein additives Fertigungsverfahren verwendet wird. Insbesondere kann ein Laserschmelzen oder eine Kombination aus Lasersintern und Laserschmelzen angewendet werden. Aber auch andere additive Fertigungsverfahren, wie im Folgenden weiter erläutert, können zur Herstellung verwendet werden.

Als additive Fertigungsverfahren im Sinne dieser Anmeldung sollen Verfahren verstanden werden, bei denen das Material, aus dem ein Bauteil hergestellt werden soll, dem Bauteil während der Entstehung hinzugefügt wird. Dabei entsteht das Bauteil bereits in seiner endgültigen Gestalt oder zumindest annähernd in dieser Gestalt. Das Baumaterial kann beispielsweise pulverförmig oder flüssig sein, wobei durch das additive Fertigungsverfahren das Material zur Herstellung des Bauteils chemisch oder physikalisch verfestigt wird.

Um das Bauteil herstellen zu können, werden das Bauteil beschreibende Daten (CAD-Modell) für das gewählte additive Fertigungsverfahren aufbereitet. Die Daten werden zur Erstellung von Anweisungen für die Fertigungsanlage in an das Fertigungsverfahren angepasste Daten des Bauteils umgewandelt, damit in der Fertigungsanlage die geeigneten Prozessschritte zur sukzessiven Herstellung des Bauteils ablaufen können. Die Daten werden dafür so aufbereitet, dass die geometrischen Daten für die jeweils herzustellenden Lagen (Slices) des Bauteils zur Verfügung stehen, was auch als Slicen bezeichnet wird.

Als Beispiele für das additive Fertigen können das selektive Lasersintern (auch SLS für Selective Laser Sintering), das Selektive Laserschmelzen (auch SLM für Slective Laser Melting), das Elektronenstrahlschmelzen (auch EBM für Electron Beam Melting), das Laserpulverauftragsschweißen (auch LMD für Laser Metal Deposition), das Kaltgasspritzen (auch GDCS für Gas Dynamic Cold Spray) genannt werden. Diese Verfahren eignen sich insbesondere zur Verarbeitung von metallischen Werkstoffen in Form von Pulvern, mit denen Konstruktionsbauteile hergestellt werden können.

Beim SLM, SLS und EBM werden die Bauteile lagenweise in einem Pulverbett hergestellt. Diese Verfahren werden daher auch als pulverbettbasierte additive Fertigungsverfahren bezeichnet. Es wird jeweils eine Lage des Pulvers in dem Pulverbett erzeugt, die durch die Energiequelle (Laser oder Elektronenstrahl) anschließend in denjenigen Bereichen lokal aufgeschmolzen oder gesintert wird, in denen das Bauteil entstehen soll. So wird das Bauteil sukzessive lagenweise erzeugt und kann nach Fertigstellung dem Pulverbett entnommen werden.

Beim LMD und GDCS werden die Pulverteilchen direkt der Oberfläche zugeführt, auf der ein Materialauftrag erfolgen soll. Beim LMD werden die Pulverpartikel durch einen Laser direkt in der Auftreffstelle auf der Oberfläche aufgeschmolzen und bilden dabei eine Lage des zu erzeugenden Bauteils. Beim GDCS werden die Pulverpartikel stark beschleunigt, so dass sie vorrangig aufgrund ihrer kinetischen Energie bei gleichzeitiger Verformung auf der Oberfläche des Bauteils haften bleiben.

GDCS und SLS haben das Merkmal gemeinsam, dass die Pulverteilchen bei diesen Verfahren nicht vollständig aufgeschmolzen werden. Beim GDCS erfolgt ein Aufschmelzen höchstens im Randbereich der Pulverpartikel, die aufgrund der starken Verformung an ihrer Oberfläche anschmelzen können. Beim SLS wird bei Wahl der Sintertemperatur darauf geachtet, dass diese unterhalb der Schmelztemperatur der Pulverpartikel liegt. Demgegenüber liegt beim SLM, EBM und LMD der Energieeintrag betragsmäßig bewusst so hoch, dass die Pulverpartikel vollständig aufgeschmolzen werden.

Weitere Einzelheiten der Erfindung werden nachfolgend anhand der Zeichnung beschrieben. Gleiche oder sich entsprechende Zeichnungselemente sind jeweils mit den gleichen Bezugszeichen versehen und werden nur insoweit mehrfach erläutert, wie sich Unterschiede zwischen den einzelnen Figuren ergeben. Es zeigen:
- Figur 1: ein Ausführungsbeispiel der erfindungsgemäßen Kühlvorrichtung mit mehreren Wärmerohren in unterschiedlichen Varianten, geschnitten,
- Figur 2: ein Ausführungsbeispiel der erfindungsgemäßen Kühlvorrichtung mit einem Latentwärmespeicher, bestehend aus mehreren Teilräumen, geschnitten,
- Figur 3: ein Ausführungsbeispiel der erfindungsgemäßen Kühlvorrichtung mit einem als Hohlgitter ausgeführten Latentwärmespeicher, geschnitten,
- Figur 4: das Detail IV aus Figur 3 geschnitten und
- Figur 5: ein Ausführungsbeispiel der erfindungsgemäßen Verfahrens.

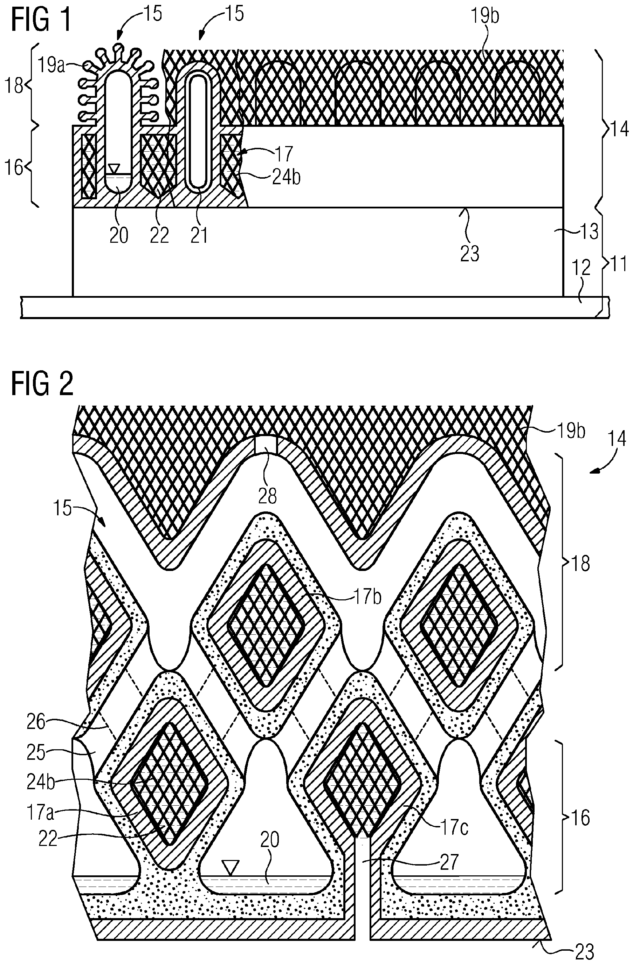

In Figur 1 ist eine elektronische Baugruppe 11 mit einem Schaltungsträger 12 und einer Baukomponente 13 in Form eines leistungselektronischen Bauelements dargestellt. Auf der Baukomponente 13 ist eine Kühlvorrichtung 14 montiert, die teilweise geschnitten in zwei Varianten dargestellt ist. Die beiden Varianten sind durch eine Bruchlinie voneinander getrennt.

Beide Varianten weisen Wärmerohre 15 auf, welche in einer Wärmeaufnahmezone 16 von einem Latentwärmespeicher 17 umgeben sind. Außerdem weisen die Wärmerohre 15 Wärmeabgabezonen 18 auf, welche mit einer passiven Kühlstruktur 19a in Form von Rippen umgeben sind (links der Bruchlinie dargestellte Variante). Alternativ kann als passive Kühlstruktur 19b auch ein Rumgitter in der Wärmeabgabezone 18 am Wärmerohr 15 angebracht sein (rechts dargestellte Variante).

Die Wärmerohre 15 sind mit einem ersten Phasenwechselmedium 20 gefüllt (in Abhängigkeit von der geforderten Betriebstemperatur kommen elementare Gase, Kohlenwasserstoffverbindungen und niedrig schmelzende Metalle in Frage). Das links dargestellte Wärmerohr der einen Variante ist als Thermosyphon ausgeführt, wobei sich das flüssige erste Phasenwechselmedium 20 in der Wärmeaufnahmezone 16 sammelt und bei Erwärmung oberhalb der Siedetemperatur verdampft. In der Wärmeabgabezone 18 kondensiert es und fließt aufgrund der Schwerkraft zurück in die Wärmeaufnahmezone 16. Alternativ, wie rechts in der zweiten Variante dargestellt, kann das Wärmerohr 15 auch als Heatpipe ausgeführt sein. Das Wärmerohr 15 ist dann mit einer kapillaren Wandstruktur 21 ausgekleidet, wobei die Kapillarkräfte in den kapillaren Kanälen (nicht dargestellt) der kapillaren Wandstruktur 21 zur Wärmeaufnahmezone 16 fließen und das verdampfende erste Phasenwechselmedium 20 verdampft und zur Wärmeabgabezone 18 strömt. Anders als bei dem oben beschriebenen Thermosyphon kann bei Verwendung von Heatpipes die Kühlvorrichtung auch in anderen als der in Figur 1 dargestellten Einbaulage verwendet werden.

Um die Wärmeaufnahmezone 16 herum ist außerdem der Latentwärmespeicher 17 angeordnet. Dieser ist mit einem zweiten Phasenwechselmedium 22 gefüllt, welches im Normalbetrieb der Baukomponente 13 fest bleibt (in Abhängigkeit von der geforderten Betriebstemperatur kommen Parafine, Salze oder Wasser zum Einsatz). Sowohl die Wärmeaufnahmezonen 16 der Wärmerohre 15 als auch der Latentwärmespeicher 17 sind in der Nähe einer Kontaktfläche 23 der Kühlvorrichtung 14 angeordnet, welche als thermische Schnittstelle zu der als Wärmequelle fungierenden Baukomponente 13 dient. Im Falle des Auftretens von thermischen Spitzenlasten in der Baukomponente 13 erwärmt sich die Kühlvorrichtung 14 stärker, so dass das zweite Phasenwechselmedium 22 im Latentwärmespeicher 17 anfängt zu schmelzen. Hierdurch wird die thermische Belastung auf die Wärmerohre 15 verringert. Damit die Wärme in dem zweiten Phasenwechselmedium 22 schnell verteilt werden kann, ist in dem Latentwärmespeicher 17 eine Wärmeleitstruktur in Form eines Raumgitters 24b vorgesehen, die sich an den Innenwänden des Latentwärmespeichers 17 abstützt.

In Figur 2 besteht das Wärmerohr 15 aus einen einzigen zusammenhängenden Raum. In diesem sind mehrere Teilräume 17a, 17b, 17c (und weitere nicht dargestellte Teilräume) untergebracht, die über Verbindungsstrukturen 25 miteinander verbunden sind. Die Verbindungsstrukturen 25 sorgen zum einen für eine Fixierung der Teilräume 17a, 17b, 17c und können außerdem über gestrichelt dargestellte Verbindungskanäle 26 verfügen. Auf diesem Wege können die Teilräume 17a, 17b, 17c über eine Öffnung 27 mit dem zweiten Phasenwechselmedium 22 befüllt werden. Anschließend wird die Öffnung in nicht dargestellter Weise verschlossen. Die Befüllung des Wärmerohrs 15 mit dem ersten Phasenwechselmedium 20 erfolgt durch eine weitere Öffnung 28, die ebenfalls in nicht dargestellter Weise nach der Befüllung verschlossen wird.

Durch die Aufteilung des Latentwärmespeichers in Teilräume 17a, 17b, 17c und deren Verbindung untereinander, entsteht eine Raumstruktur, die derart im Wärmerohr 15 angeordnet ist, dass das Wärmerohr ebenfalls eine Raumstruktur bildet, die mit der Raumstruktur des Latentwärmespeichers 17a, 17b, 17c verschachtelt ist. Hierdurch entsteht für einen Wärmeübergang zwischen Wärmerohr und Latentwärmespeicher eine vergleichsweise große Oberfläche, so dass ein Wärmeübergang im Falle von Spitzenlasten nicht nur über die Kontaktfläche 23, sondern indirekt auch über das erste Phasenwechselmedium erfolgen kann. Auch eine anschließende Kühlung des zweiten Phasenwechselmediums kann auf diesem Weg vorteilhaft schnell erfolgen.

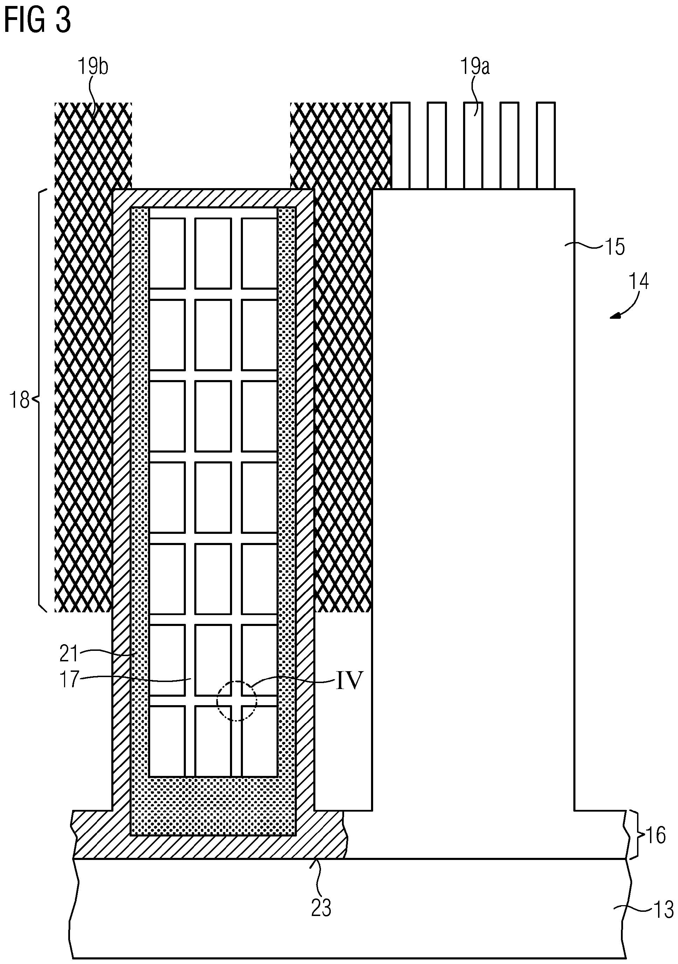

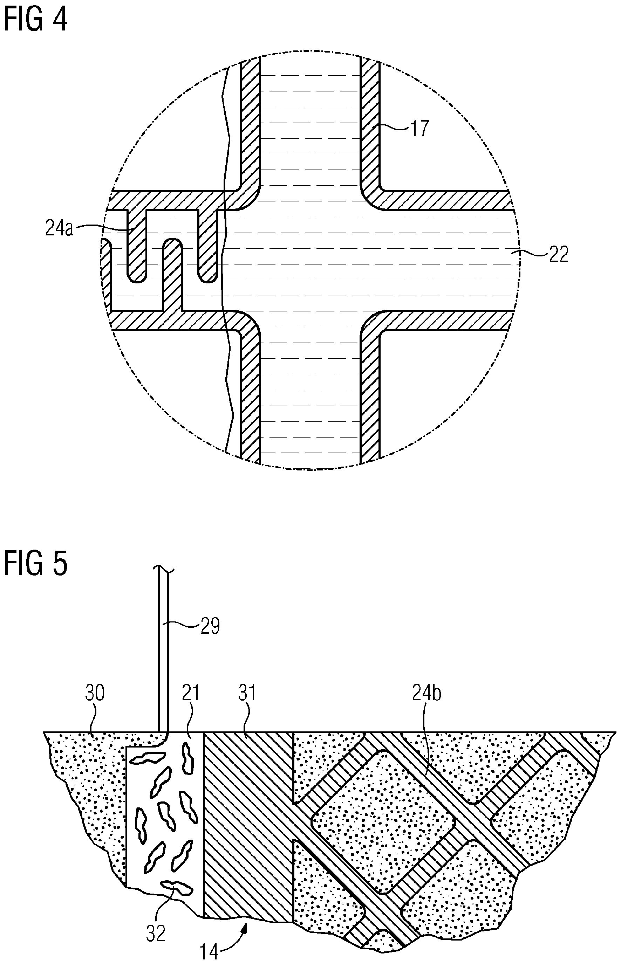

In Figur 3 sind einzeln stehende Wärmerohre 15 in Form von Heatpipes dargestellt, in deren Inneren der Latentwärmespeicher 17 in Form eines Raumgitters angeordnet ist. Wie dem Detail IV (dargestellt in Figur 4) zu entnehmen ist, ist dieses Raumgitter hohl ausgeführt, wobei in dem Hohlraum das zweite Phasenwechselmedium 22 untergebracht ist. Außerdem ist dargestellt, dass in dem hohlen Gitter Wärmeleitstrukturen 24a in Form von Rippen untergebracht sein können. Diese sind nur in einer Variante dargestellt, die durch eine Bruchlinie von dem Rest des Details IV abgetrennt ist. Alternativ kann selbstverständlich auch eine Gitterstruktur, wie in Figur 1 und 2 als 24b dargestellt, zum Einsatz kommen.

Die Wärmerohre 15 gemäß Figur 3 weisen außerdem passive Kühlstrukturen in Form von Gittern 19b und in Form von Rippen 19a auf. Diese passiven Kühlstrukturen 19a, 19b ermöglichen, wie bereits erläutert, die Abgabe von Wärme aus dem Wärmerohr 15 an die Umgebung.

Die in den Figuren 1 bis 4 dargestellten Strukturen weisen eine vergleichsweise komplexe Geometrie auf. Um diese wirtschaftlich herstellen zu können, kann beispielsweise ein Laserschmelzen und/oder ein Lasersintern als additives Fertigungsverfahren verwendet werden. Dies ist in Figur 5 dargestellt. Ein Laserstrahl 29 wird auf ein Pulverbett 30 gerichtet, welches lagenweise zu der Struktur des Bauteils verfestigt wird. In den Zwischenräumen verbleibt das Pulver des Pulverbetts 30 während der Herstellung. Die Herstellung findet in einer hierzu geeigneten Anlage statt, welche an sich bekannt ist und daher in Figur 5 nicht dargestellt ist.

Um eine massive Wandstruktur 31 des Wärmerohres und die Wärmeleitstruktur 24b herzustellen, wird der Laserstrahl 29 zur Durchführung eines selektiven Laserschmelzens verwendet. Hierbei entstehen durch Aufschmelzen des Pulvers im Pulverbett 30 massive Bauteilbereiche mit einer hohen Dichte. Die kapillare Wandstruktur 21 wird mit dem Laserstrahl 29, wie in Figur 5 dargestellt, gerade hergestellt. Hierbei wird ein selektives Lasersintern verwendet, bei dem das Pulver nicht vollständig aufgeschmolzen wird, weswegen Poren 32 in der kapillaren Wandstruktur 21 verbleiben, die somit durch ein offenporiges Porensystem gebildet werden. Diese ermöglichen eine Leitung des ersten Phasenwechselmediums, so dass die Funktionsweise einer Heatpipe im Wärmerohr verwirklicht wird.

Die Porosität kann so ausgebildet sein, dass sie durch eine geeignete Belichtungsstrategie beispielsweise mittels selektivem Laserschmelzen (SLM) oder selektivem Lasersintern (SLS) hergestellt werden kann. Die Poren können dabei durch eine definierte Belichtungsstrategie erhalten werden. Einerseits ist es möglich, die Porosität durch SLS, d. h. durch einen im Vergleich zum SLM verringerten vollflächigen Energieeintrag, herzustellen. Dabei versintern die Pulverpartikel miteinander, wobei zwischen den Pulverpartikeln Zwischenräume verbleiben. Andererseits kann, wenn die Zwischenräume zwischen den Pulverpartikeln bei Durchführung eines SLS keine genügende Porosität hervorrufen, auch eine Belichtungsstrategie gewählt werden, bei der die Oberfläche des Pulverbetts nur partiell durch SLM belichtet wird, so dass einzelne Pulverpartikel unbelichtet bleiben und später aus dem Werkstück entfernt werden können. Die Porenbildung kann durch eine statistisch verteilte, unvollständige Belichtung des Pulverbetts erzeugt werden, wobei der Verlauf der Poren bzw. der belichteten Region der jeweiligen Pulverlagen zufällig ist. Nach einer alternativen Belichtungsstrategie der betreffenden Lage folgt das unvollständige Belichtungsregime bestimmten Mustern, beispielsweise einem Linienabstand bei der Belichtung, der bewusst so groß gewählt wird, dass zwischen den Spuren unbelichtete und nicht aufgeschmolzene oder nicht angeschmolzene Partikel verbleiben. In diesen Bereichen entstehen die gewünschten Poren. Dies erreicht man beispielsweise, indem man die parallelen Spuren während der Herstellung in regelmäßigen Abständen um beispielsweise 90° verdreht. Je nach gewünschter Porengröße findet dieser Wechsel nach einer bestimmten Anzahl von Pulverlagen statt.

## Patentansprüche

1. Kühlvorrichtung mit einer thermischen Schnittstelle für eine zu kühlende Wärmequelle, wobei die Kühlvorrichtung in voneinander getrennten Volumina ein Wärmerohr (15) mit einem ersten Phasenwechselmedium (20) und einen Latentwärmespeicher (17) mit einem zweiten Phasenwechselmedium (22) aufweist, wobei
die Wärme der Wärmequelle an der thermischen Schnittstelle in eine Wärmeaufnahmezone des Wärmerohrs (15) einleitbar ist und die Schmelztemperatur des zweiten Phasenwechselmediums (22) höher ist, als die Verdampfungstemperatur des ersten Phasenwechselmediums (20), **dadurch gekennzeichnet, dass** das Wärmerohr (15) und der Latentwärmespeicher (17) durch zwei ineinander verschachtelte Raumstrukturen gebildet sind.

2. Kühlvorrichtung nach Anspruch 1, wobei die Schmelztemperatur des zweiten Phasenwechselmediums (22) weniger als 20 K, bevorzugt weniger als 10 K, höher ist als die Verdampfungstemperatur (20) des ersten Phasenwechselmediums.
wobei

3. Kühlvorrichtung nach Anspruch 1, wobei der Latentwärmespeicher (17) durch ein hohles Raumgitter gebildet wird, wobei
• das zweite Phasenwechselmedium (22) in einem in dem Raumgitter als Latentwärmespeicher (17) gebildeten Hohlraum eingeschlossen ist und
• das erste Phasenwechselmedium (20) in durch das Gitter gebildeten Gitterzwischenräumen untergebracht ist.

4. Kühlvorrichtung nach einem der Ansprüche 1 oder 2, wobei der Latentwärmespeicher eine Vielzahl von Teilräumen (17a, 17b, 17c) aufweist, die im Wärmerohr (15) gehalten sind.

5. Kühlvorrichtung nach Anspruch 4, wobei die Teilräume (17a, 17b, 17c) untereinander fluidisch verbunden sind.

6. Kühlvorrichtung nach einem der Ansprüche 1 oder 2, wobei mehrere Wärmerohre (15) vorgesehen sind, die von dem Latentwärmespeicher (17) umgeben sind.

7. Kühlvorrichtung nach einem der voranstehenden Ansprüche, wobei das mindestens eine Wärmerohr (15) in einer Wärmeabgabezone (18) außen mit einer passiven Kühlstruktur (19a, 19b) versehen ist.

8. Kühlvorrichtung nach Anspruch 7, wobei die passive Kühlstruktur (19a, 19b) Rippen und/oder ein Raumgitter aufweist.

9. Kühlvorrichtung nach einem der voranstehenden Ansprüche, wobei das mindestens eine Wärmerohr (15) als Heatpipe in einem Stück mit einer kapillaren Wandstruktur (21) ausgeführt ist.

10. Kühlvorrichtung nach einem der voranstehenden Ansprüche, wobei in dem Latentwärmespeicher (17) eine Wärmeleitstruktur (24a, 24b) angeordnet ist, die mit der Wand des Latentwärmespeichers (17) verbunden ist.

11. Kühlvorrichtung nach Anspruch 10, wobei die Wärmeleitstruktur (24a, 24b) Rippen und/oder ein Raumgitter aufweist.

12. Elektronische Schaltung mit einer zu kühlenden Baukomponente (13), wobei die Baukomponente (13) mit der thermischen Schnittstelle einer Kühlvorrichtung (14) nach einem der voranstehenden Ansprüche verbunden ist.

13. Elektronische Schaltung nach Anspruch 12, wobei die maximal mögliche Kühlleisung des Wärmerohrs (15) der Kühlvorrichtung (14)
• größer oder gleich der Wärmeleistung der Baukomponente (13) bei Nennlast aber
• kleiner als die Wärmeleistung der Baukomponente (13) bei einer zugelassenen Spitzenlast ist.

14. Verfahren zum Herstellen einer Kühlvorrichtung (14) nach einem der Ansprüche 1 bis 11, wobei zur Herstellung ein additives Fertigungsverfahren, insbesondere ein Laserschmelzen oder eine Kombination aus Lasersintern und Laserschmelzen, verwendet wird.

15. Kühlvorrichtung nach einem der Ansprüche 1 bis 11, wobei diese mit einem additiven Fertigungsverfahren, insbesondere ein Laserschmelzen oder eine Kombination aus Lasersintern und Laserschmelzen, hergestellt ist.

16. Kühlvorrichtung, nach Anspruch 15, wobei diese in einem Stück hergestellt ist.

## Claims

1. Cooling apparatus having a thermal interface for a heat source to be cooled, wherein the cooling apparatus has a thermal pipe (15), with a first phase change medium (20), and a latent heat store (17), with a second phase change medium (22), in volumes separated from one another, wherein
the heat of the heat source is, at the thermal interface, able to be introduced into a heat absorption zone of the thermal pipe (15), and the melting temperature of the second phase change medium (22) is greater than the evaporation temperature of the first phase change medium (20), **characterized in that** the thermal pipe (15) and the latent heat store (17) are formed by two spatial structures nested one inside the other.

2. Cooling apparatus according to Claim 1, wherein the melting temperature of the second phase change medium (22) is less than 20 K, preferably less than 10 K, greater than the evaporation temperature (20) of the first phase change medium.

3. Cooling apparatus according to Claim 1, wherein the latent heat store (17) is formed by a hollow spatial lattice, wherein
• the second phase change medium (22) is enclosed in a hollow space which is formed as a latent heat store (17) in the spatial lattice, and
• the first phase change medium (20) is accommodated in lattice intermediate spaces formed by the lattice.

4. Cooling apparatus according to either of Claims 1 and 2, wherein the latent heat store has a multiplicity of partial spaces (17a, 17b, 17c), which are held in the thermal pipe (15) .

5. Cooling apparatus according to Claim 4, wherein the partial spaces (17a, 17b, 17c) are fluidically connected to one another.

6. Cooling apparatus according to either of Claims 1 and 2, wherein provision is made of multiple thermal pipes (15), which are surrounded by the latent heat store (17).

7. Cooling apparatus according to one of the preceding claims, wherein, in a heat release zone (18), the at least one thermal pipe (15) is provided on the outside with a passive cooling structure (19a, 19b).

8. Cooling apparatus according to Claim 7, wherein the passive cooling structure (19a, 19b) has ribs and/or a spatial lattice.

9. Cooling apparatus according to one of the preceding claims, wherein the at least one thermal pipe (15) is designed in one piece with a capillary wall structure (21) in the form of a heat pipe.

10. Cooling apparatus according to one of the preceding claims, wherein a heat-conducting structure (24a, 24b) is arranged in the latent heat store (17) and is connected to the wall of the latent heat store (17).

11. Cooling apparatus according to Claim 10, wherein the heat-conducting structure (24a, 24b) has ribs and/or a spatial lattice.

12. Electronic circuit having a structural component (13) to be cooled, wherein the structural component (13) is connected to the thermal interface of a cooling apparatus (14) according to one of the preceding claims.

13. Electronic circuit according to Claim 12, wherein the maximum possible cooling power of the thermal pipe (15) of the cooling apparatus (14)
• is greater than or equal to the heating power of the structural component (13) at rated load, but
• is less than the heating power of the structural component (13) at a permitted peak load.

14. Method for producing a cooling apparatus (14) according one of Claims 1 to 11, wherein an additive manufacturing process, in particular a laser melting process or a process combining laser sintering and laser melting, is used for production.

15. Cooling apparatus according to one of Claims 1 to 11, wherein this is produced using an additive manufacturing process, in particular a laser melting process or a process combining laser sintering and laser melting.

16. Cooling apparatus according to Claim 15, wherein this is produced in one piece.

## Revendications

1. Dispositif de refroidissement, comprenant une interface thermique pour au moins une source de chaleur à refroidir, le dispositif de refroidissement ayant, dans des volumes séparés l'un de l'autre, un tube (15) échangeur de chaleur ayant un premier fluide (20) à changement de phase et un accumulateur (17) de chaleur latente ayant un deuxième fluide (22) à changement de phase, dans lequel
la chaleur de la source de chaleur peut être envoyée à l'interface thermique dans une zone d'absorption de la chaleur de l'échangeur (15) de chaleur et le point de fusion du deuxième fluide (22) à changement de phase est plus haut que le point d'évaporation du premier fluide (20) à changement de phase, **caractérisé en ce que** le tube (15) échangeur de chaleur et l'accumulateur (17) de chaleur latente sont formés de deux structures dans l'espace imbriquées l'une dans l'autre.

2. Dispositif de refroidissement suivant la revendication 1, dans lequel le point de fusion du deuxième fluide (22) à changement de phase de moins de 20 K, de préférence de moins de 10 K, plus haut que le point (20) d'évaporation du premier fluide à changement de phase.

3. Dispositif de refroidissement suivant la revendication 1, dans lequel l'accumulateur (17) de chaleur latente est formé d'un réseau spatial creux, dans lequel
• le deuxième fluide (22) à changement de phase est enfermé dans un espace creux formé dans le réseau spatial comme accumulateur (17) de chaleur latente et
• le premier fluide (20) à changement de phase est logé dans des espaces intermédiaires de réseau formés par le réseau.

4. Dispositif de refroidissement suivant l'une des revendications 1 ou 2, dans lequel l'accumulateur de chaleur latente a une pluralité d'espaces (17a, 17b, 17c) partiels, qui sont maintenus dans le tube (15) échangeur de chaleur.

5. Dispositif de refroidissement suivant la revendication 4, dans lequel les espaces (17a, 17b, 17c) partiels communiquent entre eux fluidiquement.

6. Dispositif de refroidissement suivant l'une des revendications 1 ou 2, dans lequel il est prévu plusieurs tubes (15) échangeurs de chaleur, qui sont entourés de l'accumulateur (17) de chaleur latente.

7. Dispositif de refroidissement suivant l'une des revendications précédentes, dans lequel le au moins un tube (15) échangeur de chaleur est pourvu, dans une zone (18) de cession de chaleur à l'extérieur, d'une structure (19a, 19b) passive de refroidissement.

8. Dispositif de refroidissement suivant la revendication 7, dans lequel la structure (19a, 19b) passive de refroidissement a des nervures et/ou un réseau spatial.

9. Dispositif de refroidissement suivant l'une des revendications précédentes, dans lequel le au moins un tube (15) échangeur de chaleur est réalisé sous la forme d'un heatpipe en une pièce en ayant une structure (21) de paroi capillaire.

10. Dispositif de refroidissement suivant l'une des revendications précédentes, dans lequel, dans l'accumulateur (17) de chaleur latente, est disposée une structure (24a, 24b) de conduction de la chaleur, qui est reliée à la paroi de l'accumulateur (17) de chaleur latente.

11. Dispositif de refroidissement suivant la revendication 10, dans lequel la structure (24a, 24b) conductrice de la chaleur a des nervures et/ou un réseau spatial.

12. Circuit électronique, comprenant un composant (13) à refroidir, le composant (13) étant relié à l'interface thermique d'un dispositif (14) de refroidissement suivant l'une des revendications précédentes.

13. Circuit électronique suivant la revendication 12, dans lequel la puissance de refroidissement possible au maximum du tube (15) échangeur de chaleur du dispositif (14) de refroidissement
• est supérieure ou égale à la puissance calorifique du composant (13) à la charge nominale, mais
• plus petite que la puissance calorifique du composant (13) à une charge de pointe autorisée.

14. Procédé de fabrication d'un dispositif (14) de refroidissement suivant l'une des revendications 1 à 11, dans lequel on utilise pour la fabrication un procédé de fabrication additif, notamment une fusion laser ou une combinaison d'un frittage laser et d'une fusion laser.

15. Dispositif de refroidissement suivant l'une des revendications 1 à 11, dans lequel celui-ci est fabriqué par un procédé de fabrication additif, notamment par une fusion laser ou une combinaison d'un frittage laser et d'une fusion laser.

16. Dispositif de refroidissement suivant la revendication 15, dans lequel celui-ci est fabriqué en une seule pièce.
